# EUROPEAN PATENT SPECIFICATION

(11) **EP 1 868 250 B1**
(45) Date of publication and mention of the grant of the patent: **25.01.2012**
(21) Application number: 07252359.0
(22) Date of filing: 11.06.2007
(51) Int. Cl.: H01L 31/05

(54) **Photovoltaic module with integrated current collection and interconnection**
Fotovoltaikmodul mit integrierter Stromabnahme und Zwischenverbindung
Module photovoltaïque ayant une collecte de courant et une interconnexion intégrées

(30) Priority: 13.06.2006 US 451604; 13.06.2006 US 451616
(43) Date of publication of application: 19.12.2007
(73) Proprietor: Miasole, Santa Clara, CA 95051 (US)
(72) Inventor: Hachtmann, Bruce,c/o Miasole, California 95051 (US); Jaiswal, Shefali, c/o Miasole, California 95051 (US); Pearce, David, c/o Miasole, California 95051 (US); Paulson, Puthur, c/o Miasole, California 95051 (US); Sanders, William, c/o Miasole, California 95051 (US); Tarbell, Ben, c/o Miasole, California 95051 (US)
(74) Representative: Loveless, Ian Mark

(56) References cited:
- EP-A1- 0 949 686
- CA-A1- 2 335 159
- DE-A1- 2 757 301
- DE-T5- 10 393 252
- JP-A- 60 128 647
- US-A- 3 553 030
- US-A- 4 652 693
- US-A- 5 391 235
- US-A- 6 114 046
- US-A1- 2006 180 195
- US-B1- 6 184 457

## Description

### FIELD OF THE INVENTION

The present invention relates generally to a photovoltaic device and more particularly to photovoltaic modules having an integrated current collection and interconnection configuration.

### BACKGROUND

Many current collection methods in photovoltaic ("PV") devices (which are also known as solar cell devices) use conductive inks that are screen printed on the surface of the PV cell. Alternative current collection methods involve conductive wires that are placed in contact with the cell.

A large portion of prior art PV cells are interconnected by using the so-called "tab and string" technique of soldering two or three conductive ribbons between the front and back surfaces of adjacent cells. Alternative interconnect configurations include shingled interconnects with conductive adhesives. Some prior art PV devices also include embossing of an adhesive backed metal foil to enhance conductivity of the substrate of the device.

However, the "tab and string" interconnection configuration suffers from poor yield and reliability due to solder joints that fail from thermal coefficient of expansion mismatches and defects, requires significant labor or capital equipment to assemble, and does not pack the cells in a PV module very closely. In addition, previous attempts at shingled interconnects have been plagued by reliability problems from degradation of the conductive adhesives used.

Prior art interconnection configurations are disclosed in document US-B-6 184 457.

### SUMMARY OF SPECIFIC EMBODIMENTS

The present invention is defined by a device according to claim 1 and by a method according to claim 3.

One embodiment of the invention includes a photovoltaic module comprising a first photovoltaic cell, a second photovoltaic cell, and a collector-connector which is configured to collect current from the first photovoltaic cell and to electrically connect the first photovoltaic cell with the second photovoltaic cell.

Another embodiment of the invention includes a photovoltaic module comprising a first photovoltaic cell, a second photovoltaic cell, and an interconnect comprising an electrically insulating carrier and at least one electrical conductor which electrically connects the first photovoltaic cell to the second photovoltaic cell.

Another embodiment of the invention includes a photovoltaic module comprising a first thermal plastic olefin sheet, a second flexible membrane roofing sheet, a plurality photovoltaic cells located between the first and the second sheets, and a plurality of electrical conductors which electrically interconnect the plurality of photovoltaic cells.

### BRIEF DESCRIPTION OF THE DRAWINGS

Figures 1-12B are schematic illustrations of the components of photovoltaic modules of examples not part of this invention and embodiments of the invention. Figures 1, 2A, 2B, 3C, 4B, 4C, 5B, 6C, 6E, 9B, 8A, 8B, 10, 11 and 12A are side cross sectional views. Figures 3A, 5A, 7A and 9A are three dimensional views. Figures 3B, 4A, 5C, 6A, 6B, 6D, 7B-7D and 12B are top views. The dimensions of the components in the Figures are not necessarily to scale.

Figures 13 and 14 are photographs of photovoltaic cells according to the examples of the invention.

### DETAILED DESCRIPTION

One embodiment of the invention provides a photovoltaic module including at least two photovoltaic cells and a collector-connector. As used herein, the term "module" includes an assembly of at least two, and preferably three or more electrically interconnected photovoltaic cells, which may also be referred to as "solar cells". The "collector-connector" is a device that acts as both a current collector to collect current from at least one photovoltaic cell of the module, and as an interconnect which electrically interconnects the at least one photovoltaic cell with at least one other photovoltaic cell of the module. In general, the collector-connector takes the current collected from each cell of the module and combines it to provide a useful current and voltage at the output connectors of the module.

Another embodiment of the invention provides a photovoltaic module which includes an interconnect comprising an electrically insulating carrier and at least one electrical conductor which electrically connects one photovoltaic cell to at least one other photovoltaic cell of the module. Preferably, but not necessarily, this interconnect comprises the collector-connector which acts as both a current collector to collect current from at least one photovoltaic cell of the module and as an interconnect which electrically interconnects the at least one photovoltaic cell with at least one other photovoltaic cell of the module.

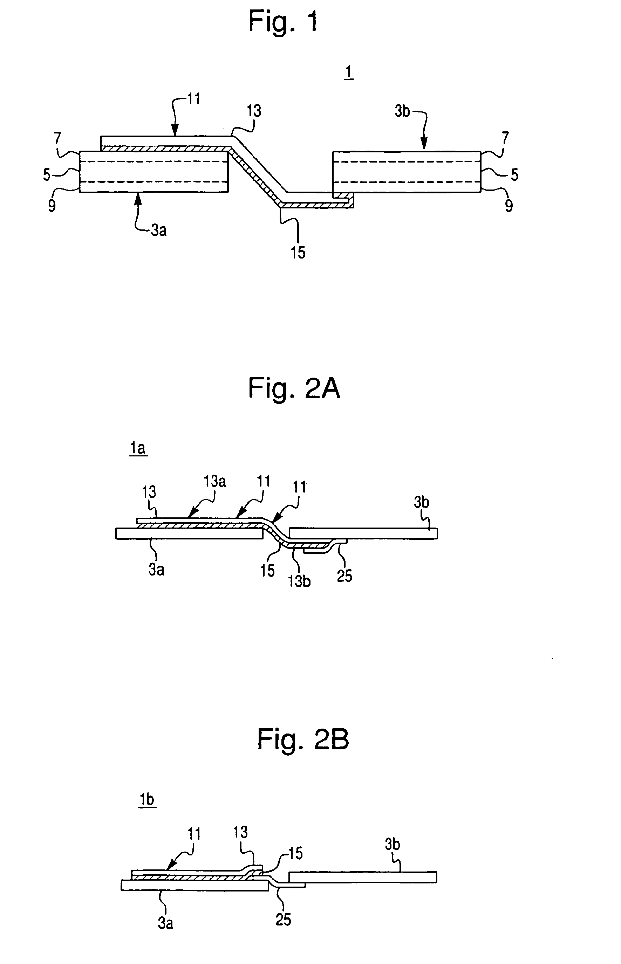

Figure 1 schematically illustrates a module 1 of the first and second examples not part of the invention. The module 1 includes first and second photovoltaic cells 3a and 3b. It should be understood that the module 1 may contain three or more cells, such as 3-10,000 cells for example. Preferably, the first 3a and the second 3b photovoltaic cells are plate shaped cells which are located adjacent to each other, as shown schematically in Figure 1. The cells may have a square, rectangular (including ribbon shape), hexagonal or other polygonal, circular, oval or irregular shape when viewed from the top.

Each cell 3a, 3b includes a photovoltaic material 5, such as a semiconductor material. For example, the photovoltaic semiconductor material may comprise a p-n or p-i-n junction in a Group IV semiconductor material, such as amorphous or crystalline silicon, a Group II-VI semiconductor material, such as CdTe or CdS, a Group I-III-VI semiconductor material, such as CuInSe₂ (CIS) or Cu(In,Ga)Se₂ (CIGS), and/or a Group III-V semiconductor material, such as GaAs or InGaP. The p-n junctions may comprise heterojunctions of different materials, such as CIGS/CdS heterojunction, for example. Each cell 3a, 3b also contains front and back side electrodes 7, 9. These electrodes 7, 9 can be designated as first and second polarity electrodes since electrodes have an opposite polarity. For example, the front side electrode 7 may be electrically connected to an n-side of a p-n junction and the back side electrode may be electrically connected to a p-side of a p-n junction. The electrode 7 on the front surface of the cells may be an optically transparent front side electrode which is adapted to face the Sun, and may comprise a transparent conductive material such as indium tin oxide or aluminum doped zinc oxide. The electrode 9 on the back surface of the cells may be a back side electrode which is adapted to face away from the Sun, and may comprise one or more conductive materials such as copper, molybdenum, aluminum, stainless steel and/or alloys thereof. This electrode 9 may also comprise the substrate upon which the photovoltaic material 5 and the front electrode 7 are deposited during fabrication of the cells.

The module also contains the collector-connector 11, which comprises an electrically insulating carrier 13 and at least one electrical conductor 15. The collector-connector 11 electrically contacts the first polarity electrode 7 of the first photovoltaic cell 3a in such a way as to collect current from the first photovoltaic cell. For example, the electrical conductor 15 electrically contacts a major portion of a surface of the first polarity electrode 7 of the first photovoltaic cell 3a to collect current from cell 3a. The conductor 15 portion of the collector-connector 11 also electrically contacts the second polarity electrode 9 of the second photovoltaic cell 3b to electrically connect the first polarity electrode 7 of the first photovoltaic cell 3a to the second polarity electrode 9 of the second photovoltaic cell 3b.

Preferably, the carrier 13 comprises a flexible, electrically insulating polymer film having a sheet or ribbon shape, supporting at least one electrical conductor 15. Examples of suitable polymer materials include thermal polymer olefin (TPO). TPO includes any olefins which have thermoplastic properties, such as polyethylene, polypropylene, polybutylene, etc. Other polymer materials which are not significantly degraded by sunlight, such as EVA, other non-olefin thermoplastic polymers, such as fluoropolymers, acrylics or silicones, as well as multilayer laminates and co-extrusions, such as PET/EVA laminates or co-extrusions, may also be used. The insulating carrier 13 may also comprise any other electrically insulating material, such as glass or ceramic materials. The carrier 13 may be a sheet or ribbon which is unrolled from a roll or spool and which is used to support conductor(s) 15 which interconnect three or more cells 3 in a module 1. The carrier 13 may also have other suitable shapes besides sheet or ribbon shape.

The conductor 15 may comprise any electrically conductive trace or wire. Preferably, the conductor 15 is applied to an insulating carrier 13 which acts as a substrate during deposition of the conductor. The collector-connector 11 is then applied in contact with the cells 3 such that the conductor 15 contacts one or more electrodes 7, 9 of the cells 3. For example, the conductor 15 may comprise a trace, such as silver paste, for example a polymer-silver powder mixture paste, which is spread, such as screen printed, onto the carrier 13 to form a plurality of conductive traces on the carrier 13. The conductor 15 may also comprise a multilayer trace. For example, the multilayer trace may comprise a seed layer and a plated layer. The seed layer may comprise any conductive material, such as a silver filled ink or a carbon filled ink which is printed on the carrier 13 in a desired pattern. The seed layer may be formed by high speed printing, such as rotary screen printing, flat bed printing, rotary gravure printing, etc. The plated layer may comprise any conductive material which can by formed by plating, such as copper, nickel, cobalt or their alloys. The plated layer may be formed by electroplating by selectively forming the plated layer on the seed layer which is used as one of the electrodes in a plating bath. Alternatively, the plated layer may be formed by electroless plating. Alternatively, the conductor 15 may comprise a plurality of metal wires, such as copper, aluminum, and/or their alloy wires, which are supported by or attached to the carrier 13. The wires or the traces 15 electrically contact a major portion of a surface of the first polarity electrode 7 of the first photovoltaic cell 3a to collect current from this cell 3a. The wires or the traces 15 also electrically contact at least a portion of the second polarity electrode 9 of the second photovoltaic cell 3b to electrically connect this electrode 9 of cell 3b to the first polarity electrode 7 of the first photovoltaic cell 3a. The wires or traces 15 may form a grid-like contact to the electrode 7. The wires or traces 15 may include thin gridlines as well as optional thick busbars or buslines, as will be described in more detail below. If busbars or buslines are present, then the gridlines may be arranged as thin "fingers" which extend from the busbars or buslines.

The modules of the embodiments of the invention provide a current collection and interconnection configuration and method that is less expensive, more durable, and allows more light to strike the active area of the photovoltaic module than the prior art modules. The module provides collection of current from a photovoltaic ("PV") cell and the electrical interconnection of two or more PV cells for the purpose of transferring the current generated in one PV cell to adjacent cells and/or out of the photovoltaic module to the output connectors. In addition, the carrier is may be easily cut, formed, and manipulated. In addition, when interconnecting thin- film solar cells with a metallic substrate, such as stainless steel, the embodiments of the invention allow for a better thermal expansion coefficient match between the interconnecting solders used and the solar cell than with traditional solder joints on silicon PV cells. In particular, the cells of the module may be interconnected without using soldered tab and string interconnection techniques of the prior art. However, soldering may be used if desired.

Figures 2A to 11 illustrate exemplary, non-limiting configurations of the modules of examples not part of the invention and embodiments of the invention.

Figures 2A and 2B illustrate modules 1a and 1b not part of the invention, respectively, in which the carrier film 13 contains conductive traces 15 printed on one side. The traces 15 electrically contact the active surface of cell 3a (i.e., the front electrode 7 of cell 3a) collecting current generated on that cell 3a. A conductive interstitial material may be added between the conductive trace 15 and the cell 3a to improve the conduction and/or to stabilize the interface to environmental or thermal stresses. The interconnection to the second cell 3b is completed by a conductive tab 25 which contacts both the conductive trace 15 and the back side of cell 3b (i.e., the back side electrode 9 of cell 3b). The tab 25 may be continuous across the width of the cells or may comprise intermittent tabs connected to matching conductors on the cells. The electrical connection can be made with conductive interstitial material, conductive adhesive, solder, or by forcing the tab material 25 into direct intimate contact with the cell or conductive trace. Embossing the tab material 25 may improve the connection at this interface. In the configuration shown in Figure 2A, the collector-connector 11 extends over the back side of the cell 3b and the tab 25 is located over the back side of cell 3b to make an electrical contact between the trace 15 and the back side electrode of cell 3b. In the configuration of Figure 2B, the collector-connector 11 is located over the front side of the cell 3a and the tab 25 extends from the front side of cell 3a to the back side of cell 3b to electrically connect the trace 15 to the back side electrode of cell 3b.

In summary, in the module configuration of Figures 2A and 2B, the conductor 15 is located on one side of the carrier film 13. At least a first part 13a of carrier 13 is located over a front surface of the first photovoltaic cell 3a such that the conductor 15 electrically contacts the first polarity electrode 7 on the front side of the first photovoltaic cell 3a to collect current from cell 3a. An electrically conductive tab 25 electrically connects the conductor 15 to the second polarity electrode 9 of the second photovoltaic cell 3b. Furthermore, in the module 1a of Figure 2A, a second part 13b of carrier 13 extends between the first photovoltaic cell 3a and the second photovoltaic cell 3b, such that an opposite side of the carrier 13 from the side containing the conductor 15 contacts a back side of the second photovoltaic cell 3b.

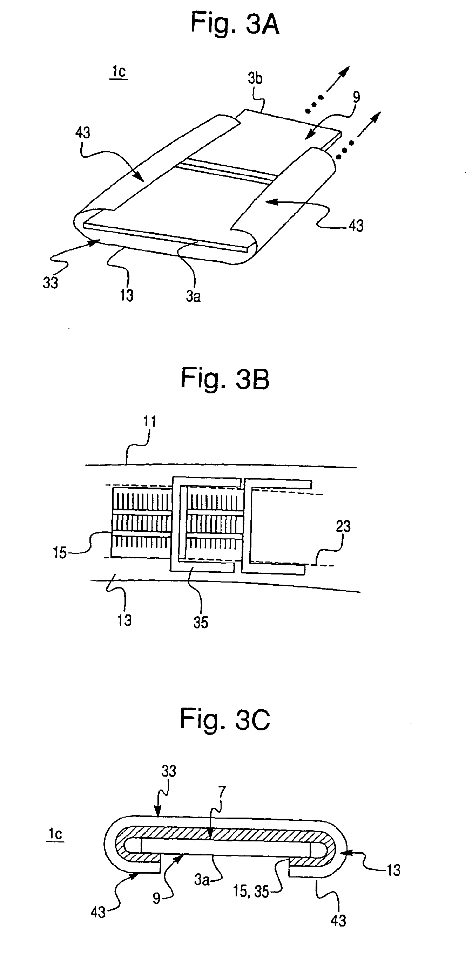

Figures 3A-3C illustrate module 1c not part of the invention having another configuration. As shown in Figure 3B, the carrier film 13 contains the conductive traces 15 printed on one side of the film 13. The film 13 is applied such that the traces 15 contact the active surface of cell 3a collecting current generated on that cell 3a. The interconnection to the next cell 3b is completed by folding the carrier film 13 as shown in Figures 3A and 3C, at the dashed lines 23 shown in Figure 3B. The large busbars 35 on the side of the carrier film 13 contact the back side (i.e., the back side electrode) of the next cell 3b in the string forming the interconnection. While two cells are shown in the Figures 3A-3C, more than two cells may be incorporated into module 1c, with the carrier film 13 being folded over the cells lined up side by side. It should be noted that the module 1c is shown upside down in Figure 3A to illustrate the fold, and the front, Sun facing side of the module 1c faces down in Figure 3A.

In summary, in the module 1c shown in Figures 3A-3C, the carrier 13 comprises a sheet comprising a first part 33 which extends over front sides of the first and the second photovoltaic cells 3a, 3b, and a second part 43 which is folded over back sides of the first and the second photovoltaic cells. The conductor 15 includes a plurality of buses 35 which extend from the first part 33 of the carrier 33 to the second part 43 of the carrier 13 to electrically connect the first polarity electrode on the front side of the first photovoltaic cell to the second polarity electrode on the back side of the second photovoltaic cell.

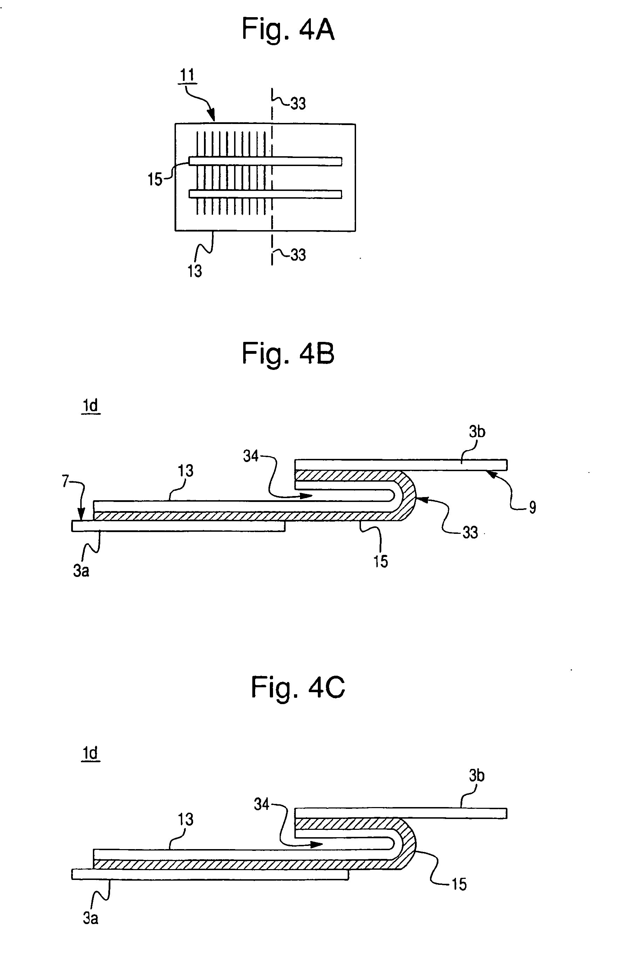

Figures 4A-4C illustrate module 1d not part of the invention having another configuration. In module 1d, the carrier film 13 contains conductive traces 15 printed on one side. The collector-conductor 11 is applied such that the traces 15 contact the active surface 7 of cell 3a collecting current generated on that cell, as shown in Figures 4B and 4C. The interconnection to the next cell 3b is completed by folding the collector-connector (i.e., the carrier film 13 and conductive trace 15 assembly) on itself at the dashed line 33 such that the extensions of the busbar traces past the fold 34 make contact to the back side 9 of the next cell 3b in the string forming the interconnection. This can be done in a shingled configuration where the cells 3a, 3b overlap, as shown in Figure 4C, or with no shading of the active area of the cell (i.e., where the cells 3a, 3b do not overlap) as shown in Figure 4B.

In summary, in module 1d, the conductor 15 is located on one side of the carrier 13. The carrier 13 is folded over such that an opposite side of the carrier is on an inside of a fold (i.e., such that the adhesive is located between two portions of the folded carrier 13). The conductor 15 electrically connects the first polarity electrode 7 on the front side of the first photovoltaic cell 3a to the second polarity electrode 9 on the back side of the second photovoltaic cell 3b.

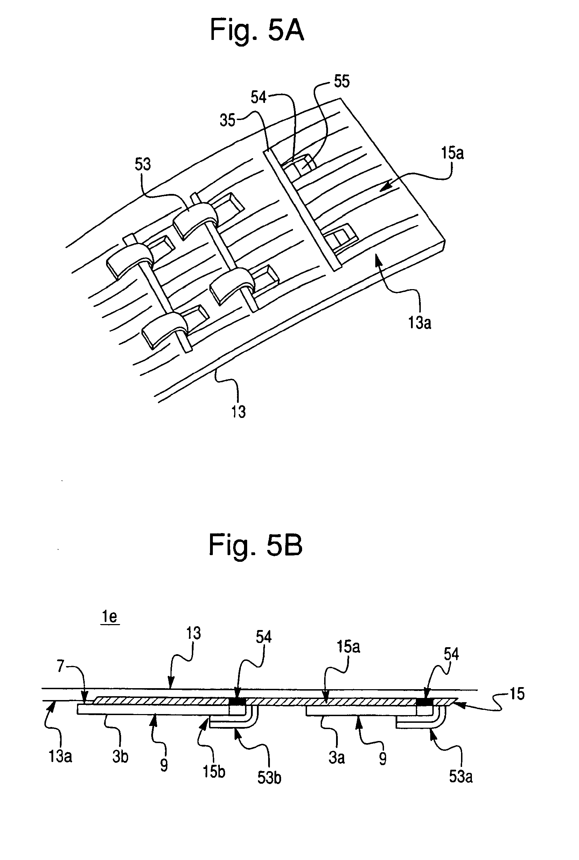

Figures 5A-5C illustrate module 1e not part of the invention having another configuration. In this configuration, the carrier film 13 also has the conductive traces 15 printed on one side, and the traces contact the active surface 7 of cell 3a collecting current generated on that cell. The interconnection to the next cell 3b is completed by piercing tabs 53 in the carrier film 13 and folding the tabs (with conductive trace 15 connected to the busbars 35) back against the underside (i.e., back side 9) of the adjacent cell 3b, thus making electrical contact between the trace 15 and the back side of the cell 3b.

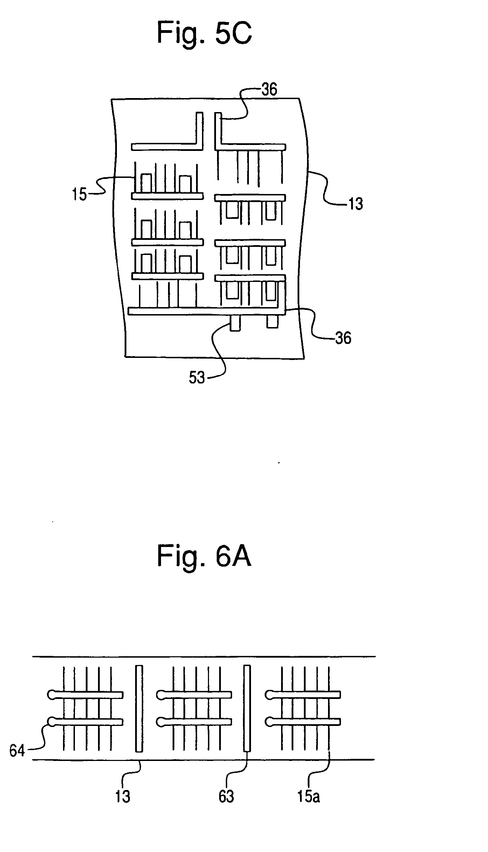

The conductive trace 15 on the tab 53 can be formed in such a way that it is printed with an insulating material in the region 54 to prevent possible shunting against the edge of the cell, and can be embossed in the region 55 (i.e., where the openings made by the removed tabs 53 in the film 13 are located) to improve electrical contact with the back side of the cell 3b. In addition, the conductive traces can be printed as shown in Figure 5C such that all of the required busbars and interconnects 36 for an entire module are printed on one side of the carrier film 13. The interconnect is made as discussed above with tabs 53. The traces 36 could plug directly into the junction box or other connector on the outside of the module 1e.

In summary, in module 1e, the carrier 13 comprises a sheet comprising a plurality of tabs 53 extending out of a first side 13a of the sheet. The conductor 15 has a first part 15a which is located on the first side 13a of the sheet 13 and a second part 15b which is located on the side of the first tab 53a facing the first side 13a of the sheet 13 when in the folded-over position. The first photovoltaic cell 3a is located between the first side 13a of the sheet 13 and the first side of the first tab 53a. The second photovoltaic cell 3b is located between the first side 13a of the sheet 13 and a first side of a second tab 53b. The first part 15a of the conductor 15 electrically contacts the first polarity electrode 7 on the front side of the first photovoltaic cell 3a. The second part 15b of the conductor 15 electrically contacts the second polarity electrode 9 on the back side of the second photovoltaic cell 3b.

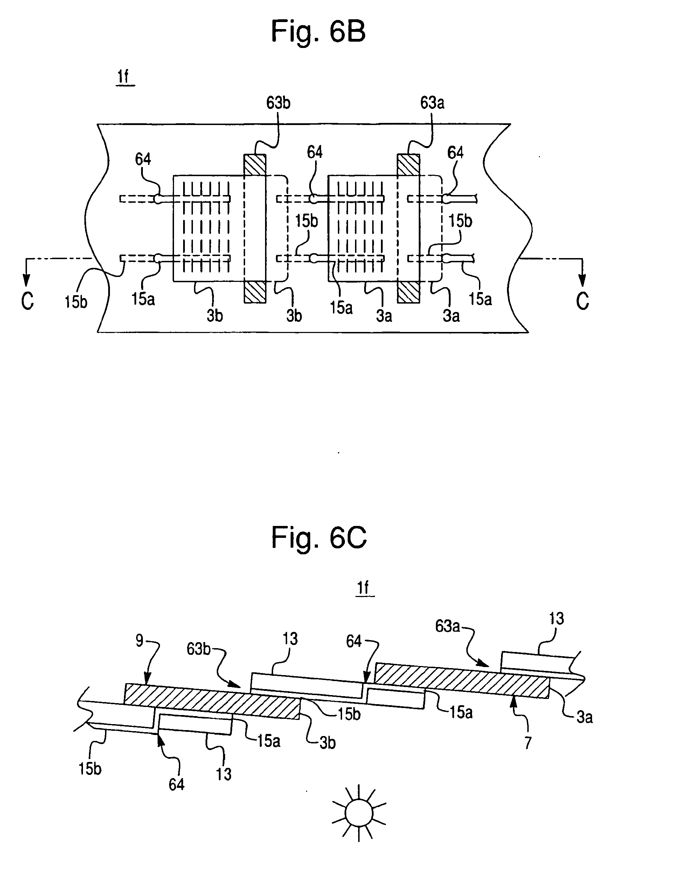

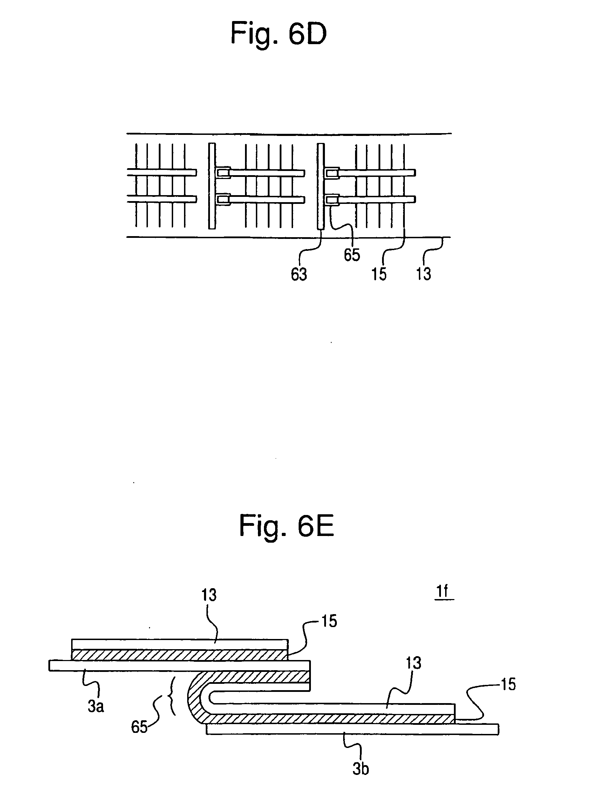

Figures 6A-6E illustrate module 1f not part of the invention having another configuration. In this configuration, full strings of interconnected cells (or modules for that matter) can be fabricated by cutting slots (i.e., slits or other shaped openings) 63 into the carrier film 13 that allow the end of the cells 3 to pass through the slot 63. As shown in Figures 6B and 6C, the cell 3a extends through the slot 63 with a part of the cell located above the carrier 13 and another part located below the carrier 13. The front and back side electrodes 7, 9 make electrical contact to the conductive traces 15a, 15b on upper and lower sides of the carrier 13.

The electrical connection can be configured as shown in Figures 6A-6C, where the traces 15a, 15b are printed on both sides of the carrier film 13. The traces 15a and 15b are electrically contiguous from front to back of the carrier film 13 in region 64 (i.e., the conductor extends through the carrier 13 or around the edge of the carrier to connect traces 15a and 15b). The back side of the portion of the cell 3b that is inserted in the slot 63 makes contact with trace 15b there only.

Alternatively, the interconnection can be made by using tabs 65, as shown in Figures 6D-6E. In this configuration, the traces 15 are printed on just one side of the carrier film 13. The tabs 65 located adjacent to the slots 63 in the carrier film can be folded back in the tab region such that contact is made between the front side of cell 3b collecting current generated on that cell and the back side of cell 3a, by the conductive trace 15 as the cells are inserted in the respective slots.

In summary, in the module 1f, the carrier 13 comprises a sheet containing a plurality of slots 63. As shown in Figures 6B and 6C, the conductor 15 has a first part 15a located on a first side of the sheet 13 between a first slot 63a and a second slot 63b, and a second part 15b located on a second side of the sheet between the first slot and the second slot. The first photovoltaic cell 3a passes through the first slot 63a such that the first polarity electrode 7 on the front side of the first photovoltaic cell 3a electrically contacts the first part 15a of the conductor 15. The second photovoltaic cell 3b passes through the second slot 63b such that the second polarity electrode 9 on the back side of the second photovoltaic cell electrically contacts the second part 15b of the conductor 15.

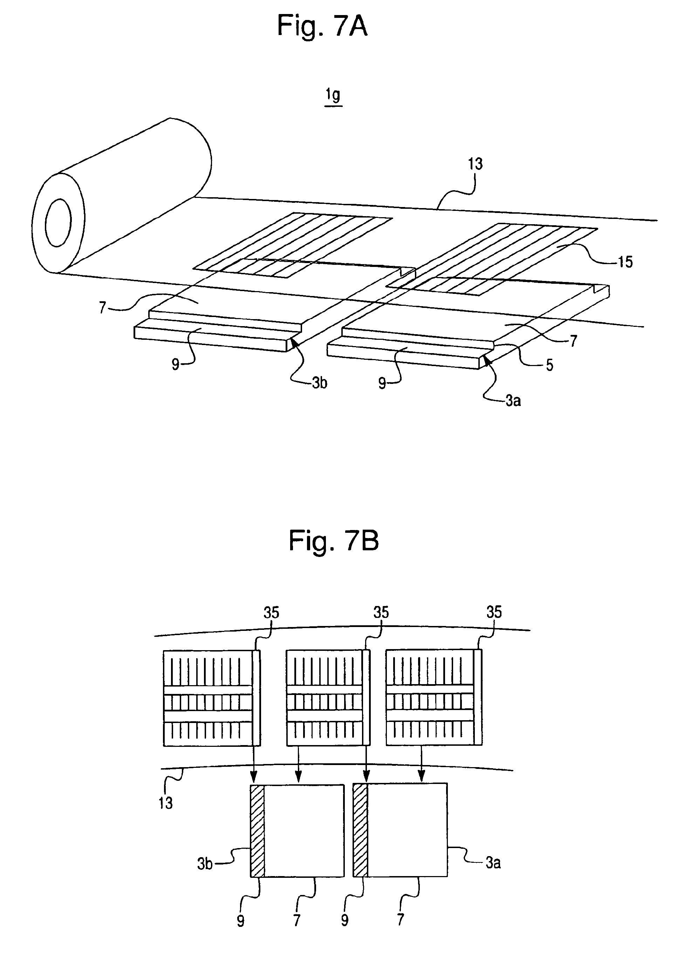

Figures 7A-7D illustrate module 1g not part of the invention having another configuration. In this configuration, the first and the second photovoltaic cells 3a, 3b comprise lateral type cells having electrodes 7, 9 of both polarities exposed on a same side of each cell. For example, as shown in Figure 7A, both electrodes 7, 9 are exposed in the front surface of the cells. The interconnection to the back contact 9 on the cells 3 can be made by selectively removing small regions of the photovoltaic film 5 from the front surface of the cells 3 thus exposing the back contact 9 in those regions.

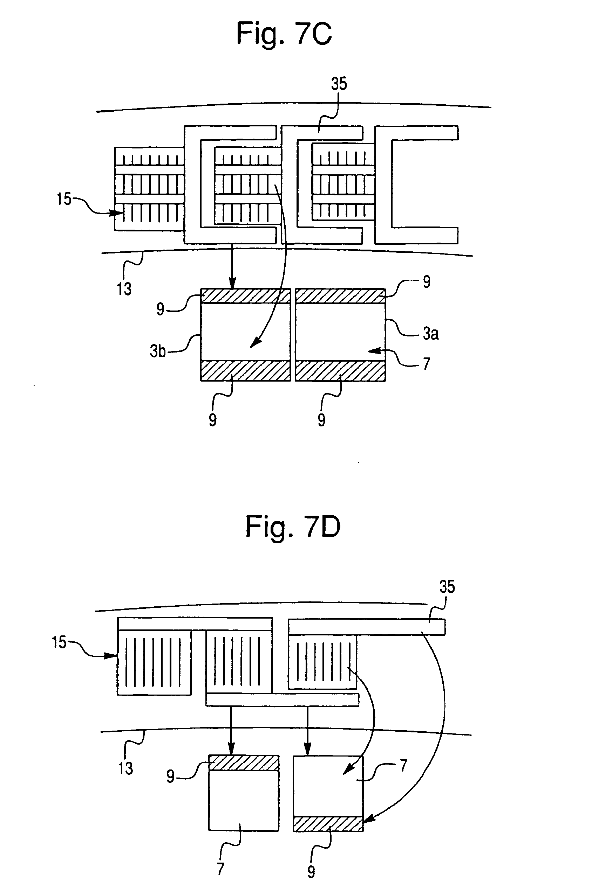

The carrier film 13 can have the conductive traces 15 printed on one side, and be applied such that the traces 15 contact the active surface (i.e., the front electrode 7) of cell 3a collecting current generated on that cell. The interconnection to the next cell 3b can be completed by extending the traces to the regions on the adjacent cells where the back contact 9 has been exposed. This can be done by connecting a bus portion 35 of the conductor 15 to a lip 9 on the front edge of the adjacent cell as shown in Figure 7B, to one or both sides of the adjacent cell as shown in Figure 7C or to alternate sides of adjacent cells as shown in Figure 7D. The carrier 13 may be in the shape of ribbon or sheet which is unrolled from a spool or roll.

In summary, in module 1g, the first and the second photovoltaic cells 3a, 3b comprise lateral type cells having electrodes 7, 9 of both polarities exposed on a same side of each cell. The conductor 15, 35 is located on one side of the carrier 13. The conductor 15, 35 electrically connects the second polarity electrode 9 of the second photovoltaic cell 3b to the first polarity electrode 7 of the first photovoltaic cell 3a as shown in Figures 7B-7D.

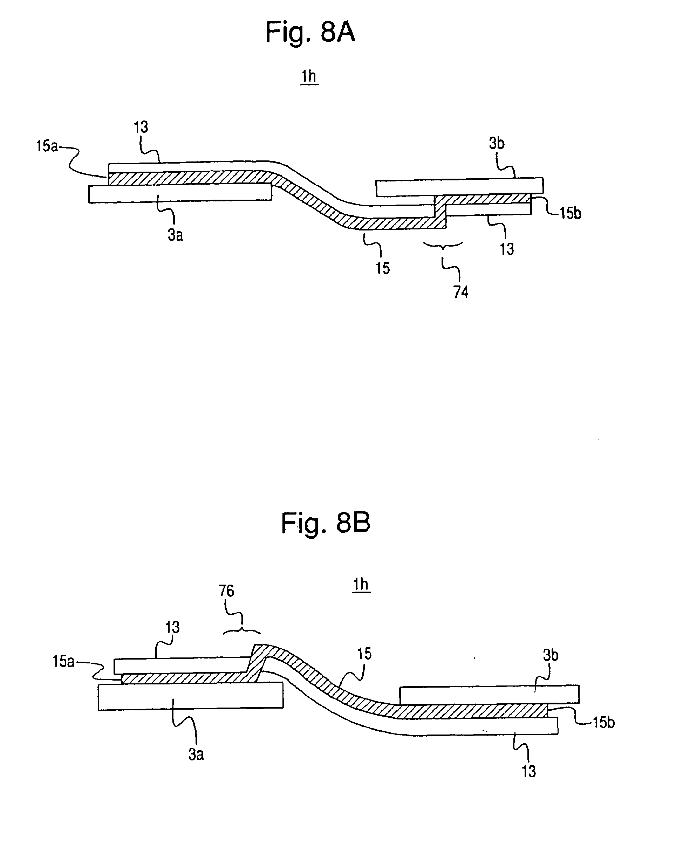

Figures 8A-8B illustrate module 1h having another configuration. In this configuration, the conductive trace 15 is formed on both sides of the carrier film 13. The conductive trace 15 is connected contiguously in selected regions to make contact to the front of one cell 3a and the back of adjacent cell 3b without folding, cutting, or twisting the carrier film 13. This can be done as shown in Figure 8A, where the trace 15 changes sides of the carrier film 13 underneath the adjacent cell 3b in region 74, or as shown in Figure 8B, where the trace switches sides on top of the cell 3a in region 76. The configuration in Figure 8B has the advantage of avoiding a possible shunt path at the edge of the cell. The region 74 or 76 may be located between the cells 3a, 3b, if desired. The conductive material 15 can be transferred to the opposite side of the cell by way of via holes, perforations made by laser or stamping techniques, or if the region 74, 76 of the carrier film 13 is permeable to the material that comprises the conductive trace, then the trace is permeated through the carrier film 13. In other words, the trace is switched from one side of the carrier film to the other side through a hole or a permeable region in the carrier 13.

In summary, in the module 1h, the conductor has a first part 15a which is located on one side of the carrier 13 and a second part 15b which is located on the opposite side of the carrier. One part of the carrier is located over a front surface of the first photovoltaic cell 3a such that the first part 15a of the conductor 15 electrically contacts the first polarity electrode 7 on a front side of the first photovoltaic cell 3a. Another part of carrier 13 extends between the first photovoltaic cell 3a and the second photovoltaic cell 3b and over a back side of the second photovoltaic cell 3b, such that the second part 15b of the conductor 15 electrically contacts the second polarity electrode 9 on a back side of the second photovoltaic cell 3b. While the module 1h is illustrated with two cells, it should be understood that the module may have more than two cells with the carrier film being shaped as a sheet or ribbon which is unrolled from a spool or roll and then cut into portions or decals which connect two cells.

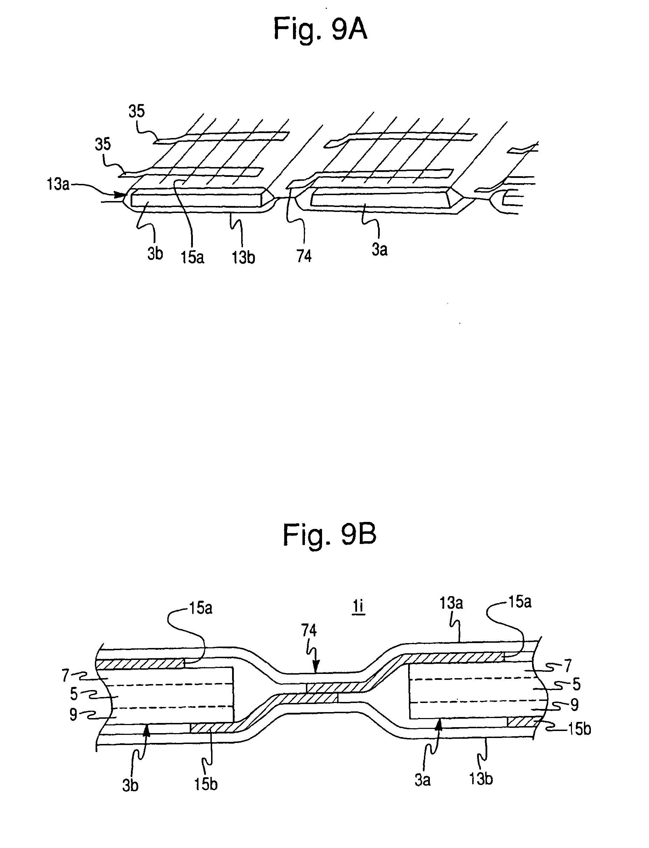

Figures 9A-9B illustrate module 1i not part of the invention having another configuration. In this configuration, the module contains two sheets or ribbons of carrier film 13a, 13b. Each carrier 13a, 13b is selectively printed with conductive traces (and/or supports wires) 15 that contact the front and back of each cell 3a, 3b such that the traces 15a that contact the front (i.e., the front electrode 7) of cell 3a collecting current generated on that cell, and the traces 15b that contact the back of cell 3b, make contact with each other in the region 74, as shown in Figure 9B. The connection in region 74 connects the traces 15a, 15b both electrically and mechanically. The connection methods include direct physical contact (i.e., pressing the traces together), solder (such as SnBi or SnPb), conductive adhesive, embossing, mechanical connection means, solvent bonding or ultrasonic bonding. If desired, the sidewalls of the cells 3 may be covered with an insulating spacer to prevent the traces 15 from short circuiting or shunting the opposite polarity electrodes 7, 9 of the same cell to each other.

In summary, the module 1i includes a collector-connector 11 which comprises a first flexible sheet or ribbon shaped, electrically insulating carrier 13a supporting a first conductor 15a, and a second flexible sheet or ribbon shaped, electrically insulating carrier 13b supporting a second conductor 15b.

The first conductor 15a electrically contacts a major portion of a surface of the first polarity electrode 7 of the first photovoltaic cell 3a. The second conductor 15b electrically contacts the first conductor 15a and at least a portion of the second polarity electrode 9 of the second photovoltaic cell 3b.

In another embodiment of the invention, the first carrier 13a comprises a passivation material of the module 1i and the second carrier 13b comprises a back support material of the module. In other words, the top carrier film 13a is the upper layer of the module which acts as the passivation and protection film of the module. The bottom carrier film 13b is the back support film which supports the module over the installation location support, such as a roof of a building, vehicle roof (including wings of plane or tops of blimps) or other structure or a solar cell stand or platform (i.e., for free standing photovoltaic modules supported on a dedicated stand or platform). The bottom carrier film may also support auxiliary electronics for connection to junction boxes.

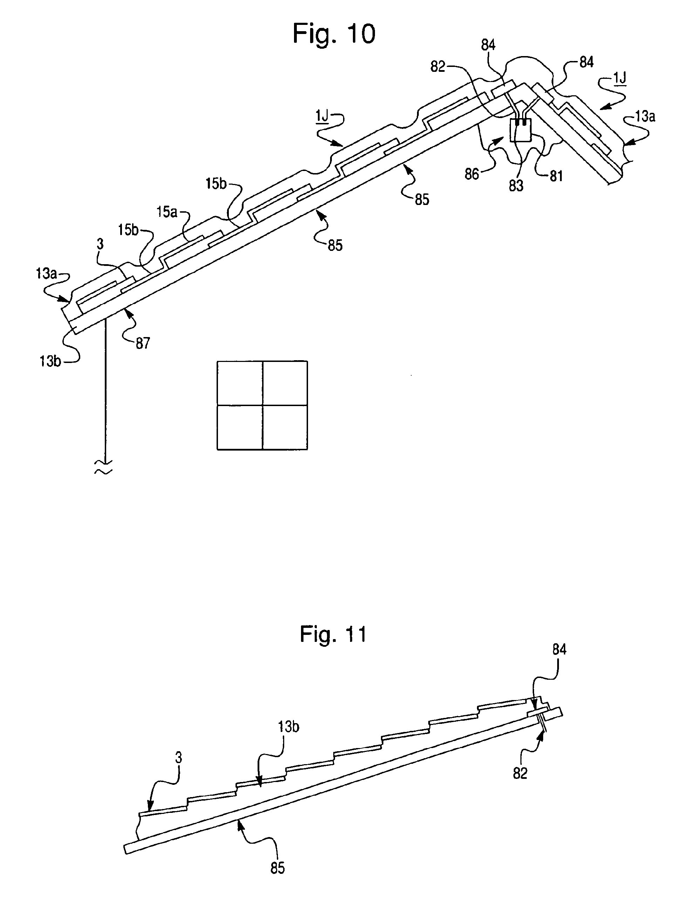

While the carriers 13 may comprise any suitable polymer materials, in one embodiment of the invention, the first carrier 13a comprises a thermal plastic olefin (TPO) sheet and the second carrier 13b comprises a second thermal plastic olefin membrane roofing material sheet which is adapted to be mounted over a roof support structure. Thus, in this aspect of the invention, the photovoltaic module 1j shown in Figure 10 includes only three elements: the first thermal plastic olefin sheet 13a supporting the upper conductors 15a on its inner surface, a second thermal plastic olefin sheet 13b supporting the lower conductors 15b on its inner surface, and a plurality photovoltaic cells 3 located between the two thermal plastic olefin sheets 13a, 13b. The electrical conductors 15a, 15b electrically interconnect the plurality of photovoltaic cells 3 in the module, as shown in Figure 10.

Preferably, this module 1j is a building integrated photovoltaic (BIPV) module which can be used instead of a roof in a building (as opposed to being installed on a roof) as shown in Figure 10. In this embodiment, the outer surface of the second thermal plastic olefin sheet 13b is attached to a roof support structure of a building, such as plywood or insulated roofing deck. Thus, the module 1j comprises a building integrated module which forms at least a portion of a roof of the building.

If desired, an adhesive is provided on the back of the solar module 1j (i.e., on the outer surface of the bottom carrier sheet 13b) and the module is adhered directly to the roof support structure, such as plywood or insulated roofing deck. Alternatively, the module 1j can be adhered to the roof support structure with mechanical fasteners, such as clamps, bolts, staples, nails, etc. As shown in Figure 10, most of the wiring can be integrated into the TPO back sheet 13b busbar print, resulting in a large area module with simplified wiring and installation. The module is simply installed in lieu of normal roofing, greatly reducing installation costs and installer markup on the labor and materials. For example, Figure 10 illustrates two modules 1j installed on a roof or a roofing deck 85 of a residential building, such as a single family house or a townhouse. Each module 1j contains output leads 82 extending from a junction box 84 located on or adjacent to the back sheet 13b. The leads 82 can be simply plugged into existing building wiring 81, such as an inverter, using a simple plug-socket connection 83 or other simple electrical connection, as shown in a cut-away view in Figure 10. For a house containing an attic 86 and eaves 87, the junction box 84 may be located in the portion of the module 1j (such as the upper portion shown in Figure 10) which is located over the attic 86 to allow the electrical connection 83 to be made in an accessible attic, to allow an electrician or other service person or installer to install and/or service the junction box and the connection by coming up to the attic rather than by removing a portion of the module or the roof.

In summary, the module 1j may comprise a flexible module in which the first thermal plastic olefin sheet 13a comprises a flexible top sheet of the module having an inner surface and an outer surface. The second thermal plastic olefin sheet 13b comprises a back sheet of the module having an inner surface and an outer surface. The plurality of photovoltaic cells 3 comprise a plurality of flexible photovoltaic cells located between the inner surface of the first thermal plastic olefin sheet 13a and the inner surface of the second thermal plastic olefin sheet 13b. The cells 3 may comprise CIGS type cells formed on flexible substrates comprising a conductive foil. The electrical conductors include flexible wires or traces 15a located on and supported by the inner surface of the first thermal plastic olefin sheet 13a, and a flexible wires or traces 15b located on and supported by the inner surface of the second thermal plastic olefin sheet 13b. As in the previous embodiments, the conductors 15 are adapted to collect current from the plurality of photovoltaic cells 3 during operation of the module and to interconnect the cells. While TPO is described as one exemplary carrier 13 material, one or both carriers 13a, 13b may be made of other insulating polymer or non-polymer materials, such as EVA and/or PET for example, or other polymers which can form a membrane roofing material. For example, the top carrier 13a may comprise an acrylic material while the back carrier 13b may comprise PVC or asphalt material.

The carriers 13 may be formed by extruding the resins to form single ply (or multi-ply if desired) membrane roofing and then rolled up into a roll. The grid lines 15 and busbars 35 are then printed on large rolls of clear TPO or other material which would form the top sheet of the solar module 1j. TPO could replace the need for EVA while doubling as a replacement for glass. A second sheet 13b of regular membrane roofing would be used as the back sheet, and can be a black or a white sheet for example. The second sheet 13b may be made of TPO or other roofing materials. As shown in Figure 10, the cells 3 are laminated between the two layers 13a, 13b of pre-printed polymer material, such as TPO.

The top TPO sheet 13a can replace both glass and EVA top laminate of the prior art rigid modules, or it can replace the Tefzel/EVA encapsulation of the prior art flexible modules. Likewise, the bottom TPO sheet 13b can replace the prior art EVA/Tedlar bottom laminate. The module 1j architecture would consist of TPO sheet 13a, conductor 15a, cells 3, conductor 15b and TPO sheet 13b, greatly reducing material costs and module assembly complexity. The modules lj can be made quite large in size and their installation is simplified. If desired, one or more luminescent dyes which convert shorter wavelength (i.e., blue or violet) portions of sunlight to longer wavelength (i.e., orange or red) light may be incorporated into the top TPO sheet 13a.

In another embodiment shown in Figure 11, the module 1k can contain PV cells 3 which are shaped as shingles to provide a conventional roofing material appearance, such as an asphalt shingle appearance, for a commercial or a residential building. This may be advantageous for buildings such as residential single family homes and townhouses located in communities that require a conventional roofing material appearance, such as in communities that contain a neighborhood association with an architectural control committee and/or strict house appearance covenants or regulations, or for commercial or residential buildings in historic preservation areas where the building codes or other similar type regulations require the roof to have a shingle type appearance. The cells 3 may be located in stepped rows on the back sheet 13b, as shown in Figure 11 (the optically transparent front sheet 13a is not shown for clarity) to give an appearance that the roof is covered with shingles. Thus, the back sheet 13b may have a stepped surface facing the cells 3. The cells in each row may partially overlap over the cells in the next lower row or the cells in adjacent rows may avoid overlapping as shown in Figure 11 to increase the available light receiving area of each cell. The layered look of shingles could be achieved in the factory along with greatly simplified in the field wiring requirements to lower module and installation costs.

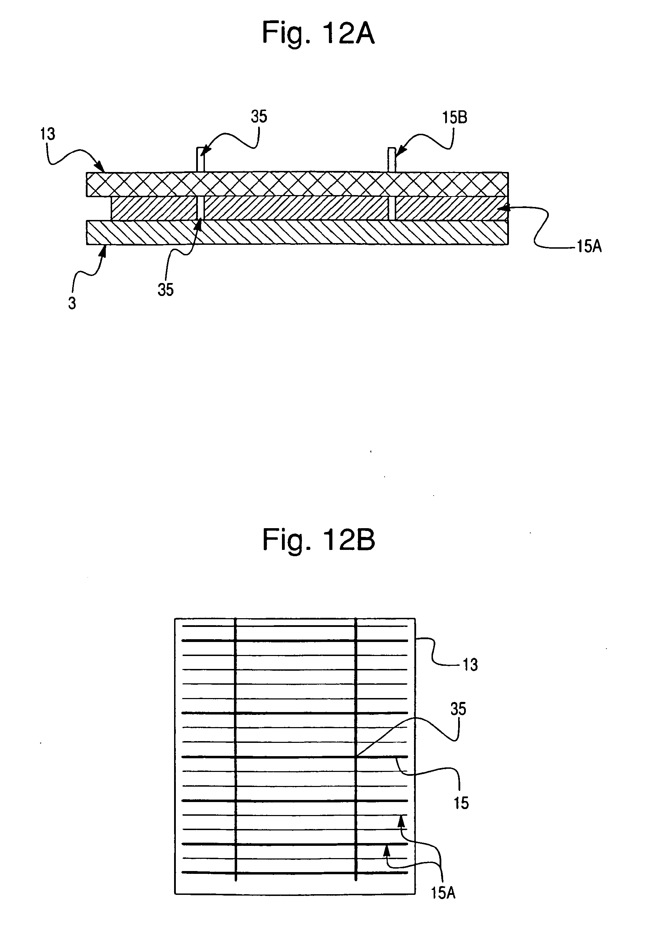

Figure 12A illustrates the side cross sectional view of a PV cell 3 according to another embodiment of the invention. This cell 3 may be used as a "drop-in" replacement for a non-functioning or malfunctioning cell in a module. Alternatively, the cell 3 may be included in an original module (i.e., in a new or originally constructed module). The cell 3 contains a carrier 13 with conductor portions 15a and 15b located on inner and outer surfaces of the carrier 13, respectively. For example, the conductor portions 15a and 15b may be printed and/or plated on both sides of the carrier 13 and connected to each other through hole(s) or via(s) (not shown in Figure 12A for clarity) in the carrier. The conductor portion 15a on the inner side of the carrier 13 may comprise both thick buslines 35 and thin grid lines 15 which are used to collect current from the cell 3. The buslines 35 on the inner side of the carrier are electrically connected to the buslines 35 which make up the conductor portion 15b on the outer side of the carrier 13. The conductor portion 15b can be electrically connected to the next cell in the module using the conventional tab and string interconnect or other suitable interconnects. Thus, in summary, the conductor portion 15a is located on a inner side of insulating carrier 13 and facing the front side electrode 7 of the cell 3, such that the conductor portion 15a contacts the front side electrode 7 to collect current from the front side electrode. The other conductor portion 15b is located on an outer side of the insulating carrier 13 and is electrically connected to the first conductor portion 15a. An interconnect, such as a tab and string or other interconnect can be electrically connected to the conductor portion 15b to electrically connect the front electrode 7 of the cell 3 to a back side electrode of another photovoltaic cell in a module. Thus, the cell 3 can be used in any type of module, such as a module in which the cells are interconnected using the conventional tab and string interconnects. Furthermore, the cell 3 may contain any suitable photovoltaic material 5 described above. Thus, a cell 3 with a CIGS photovoltaic material 5 may be used as a replacement for another CIGS PV material containing cell, while a cell with a silicon photovoltaic material 5 may be used as a replacement for another silicon PV material containing cell.

Specific Examples

The following specific examples are provided for illustration only and should not be considered limiting on the scope of the invention.

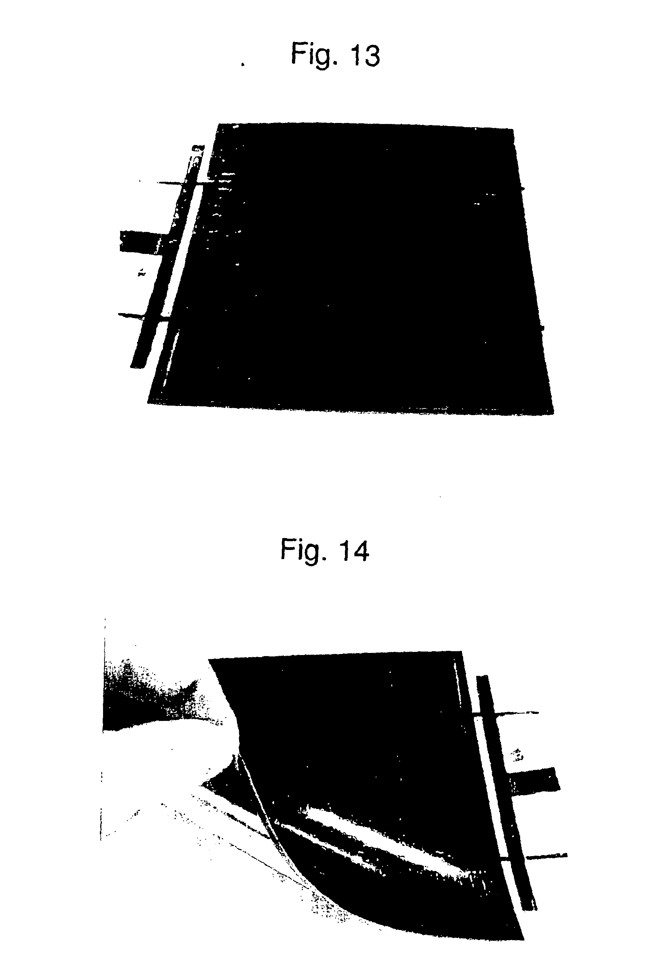

Figures 13 and 14 are photographs of flexible CIGS PV cells formed on flexible stainless steel substrates. The collector-connector containing a flexible insulating carrier and conductive traces shown in Figure 2a and described above is formed over the top of the cells. The carrier comprises a PET/EVA co-extrusion and the conductor comprises electrolessly plated copper traces. Figure 14 illustrates the flexible nature of the cell, which is being lifted and bent by hand.

Table I below shows the electrical characteristics of three cells according to the specific embodiments of the invention.

**Table I**

| Cell No. | V_{oc} | I_{sc} | Vₚₘₐₓ | Iₚₘₐₓ | FF | Power (mW) | Efficiency |
|---|---|---|---|---|---|---|---|
| 1 | 413 | 3.7 | 255 | 2.64 | 0.44 | 673.2 | 2.99 |
| 2 | 398 | 4.13 | 237 | 2.74 | 0.40 | 649.4 | 2.89 |
| 3 | 412 | 4.15 | 250 | 2.88 | 0.42 | 720.0 | 3.20 |

Although the foregoing refers to particular preferred embodiments, it will be understood that the present invention is not so limited. It will occur to those of ordinary skill in the art that various modifications may be made to the disclosed embodiments and that such modifications are intended to be within the scope of the present invention.

## Claims

1. A photovoltaic module, comprising:
a first photovoltaic cell (3a);
a second photovoltaic cell (3b); and
a collector-connector (15) which is configured to collect current from the first photovoltaic cell (3a) and to electrically connect the first photovoltaic cell (3a) with the second photovoltaic cell (3b),
wherein:
the collector-connector (15) comprises an electrically insulating carrier (13) and a conductor that passes through the insulating carrier (13), the conductor having a first part (15A) which is located on a first side of the carrier and a second part (15B) which is located on the second side of the carrier (13);
the collector-connector (15) electrically contacts a first polarity electrode of the first photovoltaic cell (3a) in such a way as to collect current from the first photovoltaic cell (3a);
the collector-connector (15) electrically contacts a second polarity electrode of the second photovoltaic cell (3b) to electrically connect the first polarity electrode of the first photovoltaic cell (3a) to the second polarity electrode of the second photovoltaic cell (3b);
a first part of said carrier (13) is located over a front surface of the first photovoltaic cell (3a) such that the first part of the conductor (15a) electrically contacts the first polarity electrode on a front side of the first photovoltaic cell (3a); and
a second part of said carrier (13) extends between the first photovoltaic cell (3a) and the second photovoltaic cell (3b) and over a back side of the second photovoltaic cell (3b), such that the second part of the conductor (15b) electrically contacts the second polarity electrode on a back side of the second photovoltaic cell (3b).

2. The module of claim 1, wherein the conductor is a wire.

3. A method of making a photovoltaic module according to claim 1 or 2, comprising:
providing a photovoltaic material;
providing a front side electrode;
providing a back side electrode, so as to form a first photovoltaic cell;
providing an electrically insulating carrier (13) located over the front side electrode;
providing a first conductor portion (15a) located on a inner side of said insulating carrier (13) and facing the front side electrode, such that the first conductor portion (15a) contacts the front side electrode to collect current from the front side electrode; and
providing a second conductor portion (15b) located on an outer side of the insulating carrier (13) and electrically connected to the first conductor portion (15a),
wherein the first (15a) and second (15b) conductor portions are part of a conductor and the conductor passes through the insulating carrier (13).

4. The method of claim 3, further comprising providing an interconnect which is electrically connected to the second conductor portion and which is adapted to electrically connect the front electrode to a back side electrode of another photovoltaic cell.

5. The method of claim 3, wherein the conductor is a wire.

## Patentansprüche

1. Fotovoltaikmodul, das Folgendes umfasst:
eine erste Fotovoltaikzelle (3a)
eine zweite Fotovoltaikzelle (3b); und
einen Kollektorverbinder (15), der zum Abnehmen von Strom von der ersten Fotovoltaikzelle (3a) und zum elektrischen Verbinden der ersten Fotovoltaikzelle mit der zweiten Fotovoltaikzelle (3b) konfiguriert ist;
wobei:
der Kollektorverbinder (15) einen elektrisch isolierenden Träger (13) und einen Leiter umfasst, der durch den isolierenden Träger (13) passiert, wobei der Leiter einen ersten Teil (15A), der sich auf einer ersten Seite des Trägers befindet, und einen zweiten Teil (15B) hat, der sich auf der zweiten Seite des Trägers (13) befindet;
der Kollektorverbinder (15) mit einer Elektrode einer ersten Polarität der ersten Fotovoltaikzelle (3a) auf eine solche Weise in elektrischen Kontakt kommt, dass er Strom von der ersten Fotovoltaikzelle (3a) abnimmt;
der Kollektorverbinder (15) mit einer Elektrode einer zweiten Polarität der zweiten Fotovoltaikzelle (3b) in elektrischen Kontakt kommt, um die Elektrode der ersten Polarität der ersten Fotovoltaikzelle (3a) mit der Elektrode der zweiten Polarität der zweiten Fotovoltaikzelle (3b) elektrisch zu verbinden;
ein erster Teil des genannten Trägers (13) sich über einer Frontfläche der ersten Fotovoltaikzelle (3a) befindet, so dass der erste Teil des Leiters (15a) mit der Elektrode der ersten Polarität auf einer Frontseite der ersten Fotovoltaikzelle (3a) in elektrischen Kontakt kommt; und
ein zweiter Teil des genannten Trägers (13) zwischen der ersten Fotovoltaikzelle (3a) und der zweiten Fotovoltaikzelle (3b) und über eine Rückseite der zweiten Fotovoltaikzelle (3b) verläuft, so dass der zweite Teil des Leiters (15b) mit der Elektrode der zweiten Polarität auf einer Rückseite der zweiten Fotovoltaikzelle (3b) in elektrischen Kontakt kommt.

2. Modul nach Anspruch 1, wobei der Leiter ein Draht ist.

3. Verfahren zur Herstellung eines Fotovoltaikmoduls nach Anspruch 1 oder 2, das Folgendes beinhaltet:
Bereitstellen eines fotovoltaischen Materials;
Bereitstellen einer Frontseitenelektrode;
Bereitstellen einer Rückseitenelektrode, um eine erste Fotovoltaikzelle zu bilden;
Bereitstellen eines elektrisch isolierenden Trägers (13), der sich über der Frontseitenelektrode befindet;
Bereitstellen eines ersten Leiterabschnitts (15a), der sich auf einer Innenseite des genannten isolierenden Trägers (13) befindet und der Frontseitenelektrode zugewandt ist, so dass der erste Leiterabschnitt (15a) mit der Frontseitenelektrode in Kontakt kommt, um Strom von der Frontseitenelektrode abzunehmen; und
Bereitstellen eines zweiten Leiterabschnitts (15b), der sich auf einer Außenseite des genannten isolierenden Trägers (13) befindet und elektrisch mit dem ersten Leiterabschnitt (15a) verbunden ist;
wobei der erste (15a) und der zweite (15b) Leiterabschnitt Teil eines Leiters sind und der Leiter durch den isolierenden Träger (13) passiert.

4. Verfahren nach Anspruch 3, das ferner das Bereitstellen einer Zwischenverbindung umfasst, die elektrisch mit dem zweiten Leiterabschnitt verbunden und zum elektrischen Verbinden der Frontelektrode mit einer Rückseitenelektrode einer anderen Fotovoltaikzelle gestaltet ist.

5. Verfahren nach Anspruch 3, wobei der Leiter ein Draht ist.

## Revendications

1. Module photovoltaïque, comprenant :
une première cellule photovoltaïque (3a);
une deuxième cellule photovoltaïque (3b); et
un collecteur-connecteur (15) qui est configuré pour recueillir du courant de la première cellule photovoltaïque (3a) et connecter électriquement la première cellule photovoltaïque (3a) à la deuxième cellule photovoltaïque (3b),
dans lequel :
le collecteur-connecteur (15) comprend un support électriquement isolant (13) et un conducteur qui passe à travers le support isolant (13), le conducteur ayant une première partie (15a) qui est située sur un premier côté du support et une deuxième partie (15b) qui est située sur un deuxième côté du support (13);
le collecteur-connecteur (15) contacte électriquement une électrode d'une première polarité de la première cellule photovoltaïque (3a) d'une manière telle à recueillir du courant de la première cellule photovoltaïque (3a);
le collecteur-connecteur (15) contacte électriquement une électrode d'une deuxième polarité de la deuxième cellule photovoltaïque (3b) pour connecter électriquement l'électrode de la première polarité de la première cellule photovoltaïque (3a) à l'électrode de la deuxième polarité de la deuxième cellule photovoltaïque (3b);
une première partie dudit support électriquement isolant (13) est située sur une surface avant de la première cellule photovoltaïque (3a) d'une manière telle que la première partie du conducteur (15a) contacte électriquement l'électrode de la première polarité sur un côté face de la première cellule photovoltaïque (3a); et
une deuxième partie dudit support électriquement isolant (13) s'étend entre la première cellule photovoltaïque (3a) et la deuxième cellule photovoltaïque (3b) et sur un côté dos de la deuxième cellule photovoltaïque (3b) d'une manière telle que la deuxième partie du conducteur (15b) contacte électriquement l'électrode de la deuxième polarité sur un côté dos de la deuxième cellule photovoltaïque (3b).

2. Module selon la revendication 1, dans lequel le conducteur est un fil.

3. Procédé de fabrication d'un module photovoltaïque selon la revendication 1 ou 2, comprenant:
fournir un matériau photovoltaïque;
fournir une électrode de face;
fournir une électrode de dos de manière à former une première cellule photovoltaïque;
fournir un support électriquement isolant (13) situé sur l'électrode de face;
fournir une première portion de conducteur (15a) située sur un côté intérieur du support électriquement isolant (13) et faisant face à l'électrode de face, d'une manière telle que la première portion du conducteur (15a) contacte l'électrode de face pour recueillir du courant de l'électrode de face; et
fournir une deuxième portion de conducteur (15b) située sur un côté extérieur du support isolant (13) et connectée électriquement à la première portion du conducteur (15a),
où la première (15a) et la deuxième (15b) portions du conducteur font partie d'un conducteur et le conducteur passe à travers le support isolant (13).

4. Procédé selon la revendication 3, comprenant en outre fournir une interconnexion qui est électriquement connectée à la deuxième portion du conducteur et qui est adaptée pour connecter électriquement l'électrode de face à l'électrode de dos d'une autre cellule photovoltaïque.

5. Procédé selon la revendication 3, dans lequel le conducteur est un fil.
